# EUROPEAN PATENT SPECIFICATION

(11) **EP 0 622 850 B1**
(45) Date of publication and mention of the grant of the patent: **21.04.1999**
(21) Application number: 94102415.0
(22) Date of filing: 17.02.1994
(51) Int. Cl.: H01L 27/02, H01L 21/82

(54) **Process for making an electrostatic discharge protect diode for silicon-on-insulator technology**
Verfahren zum Herstellen einer Schutzdiode gegen elektrostatische Entladungen in der Silizium-auf-Insulator-Technologie
Procédé de fabrication d'une diode de protection contre des décharges électrostatiques pour une technologie silicium-sur-isolant

(30) Priority: 30.04.1993 US 54993
(43) Date of publication of application: 02.11.1994
(73) Proprietor: International Business Machines Corporation, Armonk, N.Y. 10504 (US)
(72) Inventor: Brady, Frederick T., Chantilly, Va. 22021 (US); Edenfeld, Arthur, Middlebrook, Va. 24459 (US); Haddad, Nadim F., Oakton, Va. 22124 (US)
(74) Representative: Teufel, Fritz, Dipl.-Phys.

(56) References cited:
- EP-A- 0 102 696
- EP-A- 0 437 939
- EP-A- 0 490 437
- FR-A- 2 145 460
- US-A- 3 378 915
- US-A- 4 889 829
- PATENT ABSTRACTS OF JAPAN vol. 11, no. 171 (E-512)2 June 1987 & JP-A-62 005 662 (NEC) 12 January 1987

## Description

### BACKGROUND OF THE INVENTION

This invention relates to a method of fabricating electrostatic discharge protection for semiconductor devices, formed on silicon-on-insulator substrates.

This size of semiconductor devices has shrunk and circuit layouts have become more complex. As a result, semiconductor devices in circuits are more susceptible to burn-out by electrostatic discharge (ESD) events. Various approaches for minimizing ESD burn-out have been presented. The known approaches are based on reverse-biased diodes formed in the substrate of the semiconductor material. In silicon-on-insulator (SOI) wafers, however, the devices are electrically insulated from the substrate by a layer of silicon dioxide. In thin film SOI wafers, the silicon film is too thin to form large area vertical diodes. What is needed, is a method for forming a structure to allow electrostatic discharge protection for SOI transistors.

It is mentioned that EP-A-0490437 discloses a reverse voltage diode for maximum depletion region under high voltage devices. Therein, said diode is manufactured in a late stage of IC processing but before MOSFET gate oxide growth. The formation of the diode involves a special ion implantation step additional to the implantation of the silicon-on-insulator layer.

JP-A-62005662 discloses (in its English abstract) a drain of a SOI-MOSFET having Ohmic contact to a N+/P- diode in the substrate. Said buried diode is formed with its own special diffusion step and before gate oxide growth.

US-A-4889829 shows a process for formation of bulk elements and SOI elements on the same chip to avoid a double LOCOS technology.

FR-A-2145460 shows a gate of a conventional MOSFET connected to a lateral Zener diode, both on a sapphire substrate. In a special case, the Zener diode is placed on an oxide layer common with the MOSFET gate, on a silicon substrate.

### SUMMARY OF THE INVENTION

The present invention intends to provide a simple and effective method to produce an ESD protect diode for MOSFET devices. This is achieved by means of a method according to Claim 1.

In accordance with the present invention, a new photolithography level is inserted following transistor gate oxide growth. At this new photolithographic level, the area in which a diode is to be fabricated is defined. A dry etch tool is then used to etch a trench through the gate oxide, the silicon film and the buried oxide of the SOI wafer stopping at the silicon substrate. During a source/drain doping procedure, the exposed substrate surface is doped opposite the wafer dopant type. Standard processing then continues.

It is desired that the slope of the trench wall be controlled so that it is not excessively vertical. A vertical trench wall would facilitate the formation of polysilicon or nitride or oxide spacers as part of a side wall masking. The spacers would block a dopant implant causing the electrostatic discharge diode to leaky. A second requirement is that the trench should be much wider than the sum of its depth plus the thickness of the passivation oxide. This avoids step coverage with the passivation oxide and the subsequent first metal layer.

The process steps are: gate oxide growth; defining the ESD diode area with photoresist; etching the gate oxide in exposed areas; etching the silicon film in exposed area; etching the buried oxide in exposed areas; stripping the resist; and continuing normal device processing. For a p-type substrate, during N+ source/drain photo definition the ESD diode trench should be opened to allow the N+ source/drain implant. During any P+ implant the trench should be covered with resist. Other than these steps, normal semiconductor processing is used.

In an alternative embodiment, the electrostatic protect method may be employed during mesa/trench isolation of the SOI structures not forming part of the claimed invention. In this embodiment, the process steps are as follows: gate oxide growth; defining ESD diode area with photoresist; etching through the buried oxide; stripping the resist and continuing processing the same as in LOCOS device fabrication.

### BRIEF DESCRIPTION OF THE DRAWINGS

The objects, features and advantages of the present invention will be more fully understood with reference to the description of the best mode and the drawings wherein;
- Figure 1: is cross-sectional area of a SOI wafer having gate oxide grown.
- Figure 2: is a cross-section of an isolation etched SOI wafer.
- Figure 3: is a cross-section of the wafer during source/drain implant.
- Figure 4: is a cross-section area of an alternative embodiment of the present invention using mesa/trench isolation.
- Figure 5: shows a result after etching in an alternative embodiment.
- Figure 6: shows a completed electrostatic discharge protection diode on a SOI wafer.

### DESCRIPTION OF THE BEST MODE FOR CARRYING OUT THE INVENTION

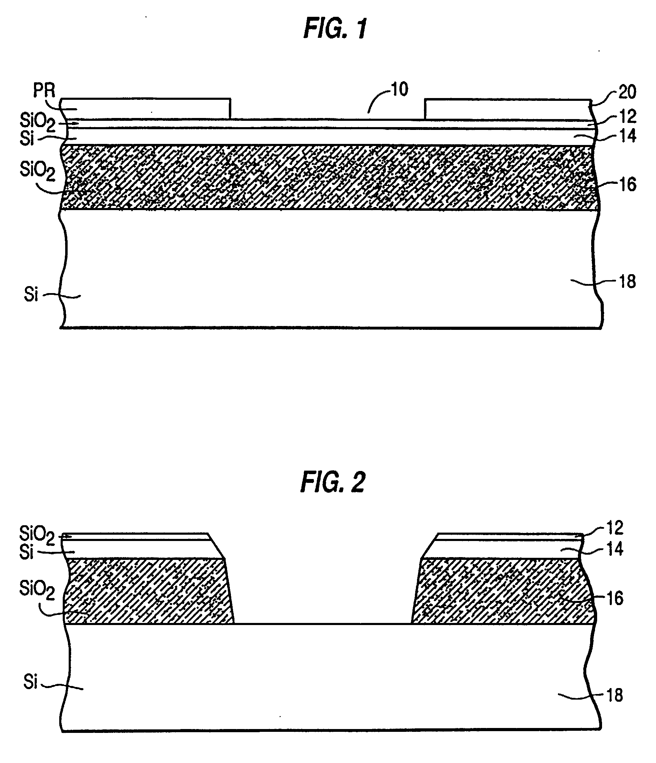

The present invention employs an additional photolithographic level in standard semiconductor device processing. This level is inserted after gate oxide growth. As can be seen in Figure 1, this photolithographic level defines an area 10 in which a diode is to be fabricated. A dry etch tool is then used to etch a trench through the grown gate oxide 12, silicon film 14 and the silicon dioxide layer 16 down to the silicon substrate 18. After photoresist 20 removal, the SOI device wafer looks as shown in Figure 2.

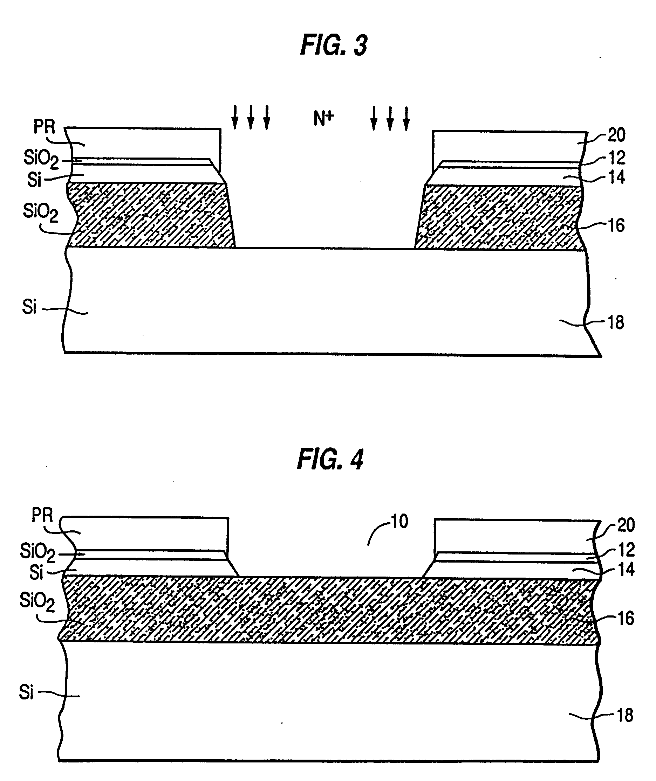

During a source/drain doping procedure, the EDS diode trench is opened up and doped with N+ implantation as shown in Figure 3. The trench is covered during any P+ doping processes to prevent implantation into the diode area. When using an N-type silicon substrate, the trench can be opened up during any P+ source/drain implantation process.

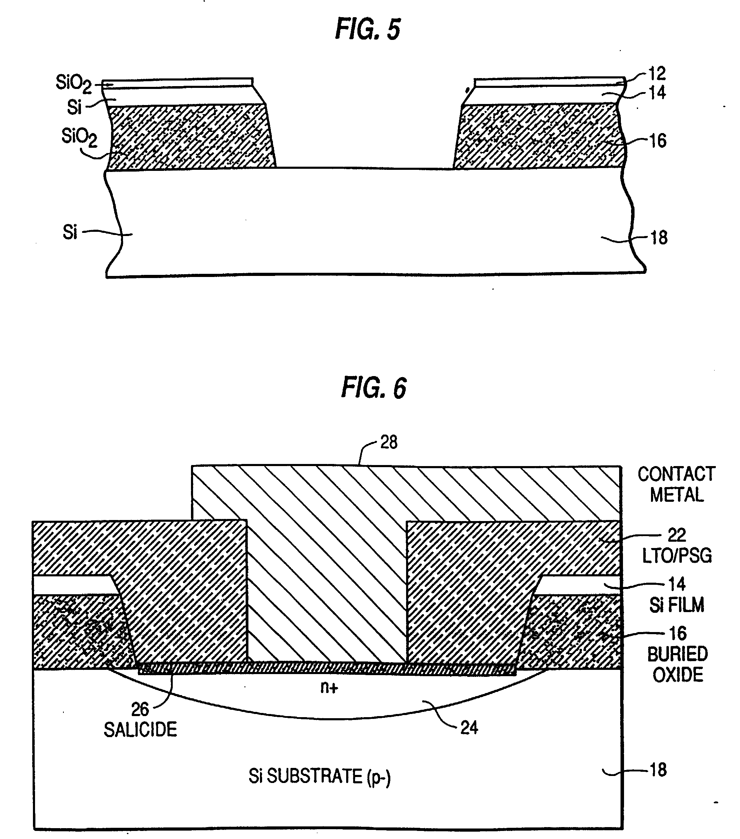

When using a mesa or trench isolation technique on SOI wafers, the process steps are nearly the same. As shown in Figure 4, the photoresist 20 can be used after the growth of gate oxide to define the EDS diode area 10. Next, the buried oxide is etched to the silicon substrate, the photoresist is striped to form the device structure as shown in Figure 5. From then on, the device processing is the same as for the LOCOS device processing technique.

Shown in Figure 6, is a cross-section of an ESD protect diode for SOI. Shown is a substrate 18 having a buried oxide 16 and a silicon film 14, in which semiconductor transistor devices are formed. A low temperature glass 22 is conformably deposited into the trench region on which the diode is formed. The diode is formed from the N+ doped region 24 with the salicide contact 26 on which the first metal layer 28 is deposited.

In addition to being used for ESD protection, the diode can be forward biased and used to check if a test probe is making proper contact with a pad this not forming part of the claimed invention. Each input and output path would have its own ESD protection associated therewith.

## Claims

1. A method of fabricating an electrostatic discharge (ESD) diode (24, 18) in a silicon-on-insulator (SOI) material (18, 16, 14) having at least a silicon layer (14) for MOSFET device fabrication, an insulating layer (16) thereunder and a semiconducting substrate (18) under the insulating layer (16), the substrate (18) having a dopant type, comprising in the following order the steps of:
growing a MOSFET gate oxide (12) on the silicon layer;
defining a trench region (10) on the surface (12) of the SOI substrate (18, 16, 14) before normal semiconductor device processing;
etching the gate oxide (12) and the SOI layers (16, 14) down to the semiconducting substrate (18) to form the trench;
removing any trench defining material and continuing with normal device processing;
opening up the trench (10) and ion implantating a dopant species of the opposite type as the semiconducting substrate (18) during processing of the MOSFET devices;
depositing metal (28) in portions of the trench region (10) during normal device processing to form a diode (24, 18), the diode metallization (28) being connected to devices formed in the said silicon layer (14) of the SOI material (16, 14) thereby providing ESD protection to the devices.

2. A method according to Claim 1 or 2, wherein before said metal (28) deposition step a low temperature glass (22) is conformably deposited into said trench (10) leaving open an area in said trench (10) for contacting said diode (24, 18).

## Patentansprüche

1. Verfahren zur Herstellung einer elektrostatischen Entladungsdiode (ESD) in einem Silicium-auf-Isolator(SOI)-Material (18, 16, 14) mit wenigstens einer Siliciumschicht (14) zur MOSFET-Bauelementfertigung, einer isolierenden Schicht (16) darunter und einem halbleitenden Substrat (18) unter der isolierenden Schicht (16), wobei das Substrat (18) einen Dotierstofftyp aufweist, wobei es folgende Schritte in der angegebenen Reihenfolge umfaßt:
Aufwachsen eines MOSFET-Gate-Oxids (12) auf der Siliciumschicht;
Definieren eines Grabengebiets (10) auf der Oberfläche (12) des SOI-Substrats (18, 16, 14) vor der normalen Halbleiterbauelementfertigung;
Ätzen des Gate-Oxids (12) und der SOI-Schichten (16, 14) bis hinunter auf das halbleitende Substrat (18), um den Graben zu bilden;
Entfernen von jeglichem grabendefinierenden Material und Fortsetzen der normalen Bauelementfertigung;
Öffnen des Grabens (10) und Ionenimplantieren einer Dotier- stoffspezies des zu dem halbleitenden Substrat (18) entgegengesetzten Typs während der Fertigung der MOSFET-Bauelemente;
Aufbringen von Metall (28) in Teile des Grabengebiets (10) während der normalen Bauelementfertigung, um eine Diode (24, 18) zu bilden, wobei die Diodenmetallisierung (28) mit Bauelementen verbunden wird, die in der Siliciumschicht (14) des SOI-Materials (16, 14) ausgebildet sind, wodurch ein ESD-Schutz für die Bauelemente bereitgestellt wird.

2. Verfahren gemäß Anspruch 1, wobei vor dem Schritt der Deposition des Metalls (28) ein Niedertemperaturglas (22) konform in dem Graben (10) aufgebracht wird, wobei eine Fläche in dem Graben (10) zur Kontaktierung der Diode (24, 18) offen bleibt.

## Revendications

1. Procédé de fabrication d'une diode de protection contre les décharges électrostatiques (ESD) (24, 18) dans un matériau de silicium sur isolant (SOI), (18, 16, 14) possédant au moins une couche de silicium (14) destinée à la fabrication de dispositifs MOSFET (transistor à effet de champ métal-oxyde-semiconducteur), une couche d'isolant (16) sous celle-ci et un substrat semiconducteur (18) sous la couche d'isolant (16), le substrat (18) comportant un type de dopant, comprenant les étapes suivantes consistant à :
faire croître un oxyde de grille de MOSFET (12) sur la couche de silicium,
définir une région de tranchée (10) sur la surface (12) du substrat SOI (18, 16, 14) avant la fabrication normale du dispositif à semiconducteur,
graver l'oxyde de la grille (12) et les couches de silicium sur isolant SOI (16, 14) jusqu'au substrat semiconducteur (18), afin de former une tranchée,
retirer tout matériau de définition de la tranchée et poursuivre la fabrication normale des dispositifs,
exposer la tranchée (18) et procéder à l'implantation ionique d'une espèce dopante du type opposé au substrat semiconducteur (18) durant la fabrication des dispositifs MOSFET,
déposer du métal (28) dans des parties de la région de la tranchée (10) durant la fabrication normale des dispositifs afin de former une diode (24, 18), la métallisation de la diode (28) étant reliée aux dispositifs formés dans ladite couche de silicium (14 ) du matériau SOI (16, 14) en réalisant de ce fait la protection contre les décharges électrostatiques (ESD) des dispositifs.

2. Procédé selon la revendication 1, dans lequel avant ladite étape de dépôt de métal (28), un verre à basse température (22) est déposé en conformité dans ladite tranchée (10) laissant ouverte dans ladite tranchée (10) une zone afin de permettre le contact de ladite diode (24, 18).
